# FASCICULE DE BREVET EUROPEEN

(11) **EP 3 432 373 B1**
(45) Date de publication et mention de la délivrance du brevet: **18.03.2020**
(21) Numéro de dépôt: 18183377.3
(22) Date de dépôt: 13.07.2018
(51) Int. Cl.: H01L 41/113, H02N 2/18

(54) **GÉNÉRATEUR PIÉZOÉLECTRIQUE**
PIEZOELEKTRISCHER GENERATOR
PIEZOELECTRIC GENERATOR

(30) Priorité: 18.07.2017 FR 1756814
(43) Date de publication de la demande: 23.01.2019
(73) Titulaire: Commissariat à l'Energie Atomique et aux Energies Alternatives, 75015 Paris (FR); Université Savoie Mont Blanc, 73011 Chambéry Cedex (FR)
(72) Inventeur: BADEL, Adrien, 73340 LESCHERAINES (FR); GASNIER, Pierre, 38100 GRENOBLE (FR); GREZAUD, Romain, 38100 GRENOBLE (FR); MOREL, Adrien, 38000 GRENOBLE (FR); PILLONNET, Gaël, 38120 PROVEYSIEUX (FR)
(74) Mandataire: Cabinet Beaumont

(56) Documents cités:
- EP-A1- 2 579 440
- US-A1- 2011 227 543
- US-A1- 2014 104 002
- US-A1- 2015 311 824

## Description

### Domaine

La présente description concerne de façon générale les systèmes de récupération d'énergie et plus particulièrement les systèmes de récupération d'énergie vibratoire. La présente description concerne plus précisément un générateur piézoélectrique.

### Exposé de l'art antérieur

Les convertisseurs d'énergie restituant une tension alternative ou continue sont largement utilisés dans les systèmes électroniques, qu'ils soient basés sur un élément électromagnétique, un élément piézoélectrique ou autre. Les générateurs piézoélectriques sont particulièrement adaptés à la microélectronique, en particulier pour des systèmes peu gourmands en énergie ou que l'on souhaite autonomes.

Toutefois, la plupart des générateurs piézoélectriques actuels ne fonctionnent correctement qu'à la fréquence de résonance du système piézoélectrique qui est intrinsèque à cet élément (liée entre autres à la nature du matériau et à la forme et aux dimensions du résonateur). Le plus souvent, on trouve des techniques dites d'extraction continue, basées sur une adaptation d'impédance résistive via un convertisseur DC/DC et des techniques d'extraction discontinue, basées sur une charge de la capacité de l'élément piézoélectrique en circuit ouvert et une décharge de cette capacité pour restituer l'énergie lorsque la tension aux bornes de l'élément piézoélectrique est maximum.

Plus récemment, on a proposé de récupérer l'énergie sur une bande de fréquences. Ces systèmes utilisent une charge réactive pour adapter la fréquence de résonance.

Par exemple, le document WO-A-2012101037 décrit un générateur piézoélectrique qui exploite le comportement inductif qu'a l'élément piézoélectrique sur une certaine bande de fréquences en adaptant l'impédance grâce à une matrice de capacités commutées. La plage de fréquences est cependant limitée à quelques Hertz en raison du couplage limité de l'élément piézoélectrique (à la matrice de capacités) . De plus, le pas du réglage est conditionné par le nombre de capacités, ce qui nuit rapidement à la taille du système. Le document US2011/0227543 est aussi de l'art antérieure pertinent.

Selon un autre exemple, on connecte une inductance commutable en parallèle sur l'élément piézoélectrique et on prélève l'énergie aux bornes de cette inductance. On contrôle alors la phase et l' amplitude de la tension aux bornes de l'élément piézoélectrique et on émule ainsi une impédance inductive ou capacitive. Toutefois, plus la fréquence d'utilisation est éloignée de la fréquence de résonnance de l'élément piézoélectrique, plus les pertes dans l'inductance sont importantes et détériorent le rendement. En pratique, cette technique ne fonctionne donc correctement qu'à la fréquence de résonnance de l'élément piézoélectrique.

On a déjà proposé d'émuler une impédance à partir d'un élément piézoélectrique en utilisant une modulation de largeurs d'impulsions (PWM) de la tension aux bornes de l'élément piézoélectrique. Le principe est de hacher la tension aux bornes de l'élément piézoélectrique et de moduler le rapport cyclique afin de contrôler la phase de la tension. Cette technique nécessite cependant une importante énergie pour commander des transistors effectuant la modulation PWM et le rendement final de la récupération d'énergie est donc faible.

### Résumé

Il existe un besoin pour un récupérateur piézoélectrique d'énergie vibratoire qui puisse fonctionner sur une large bande de fréquences. En particulier, dans la plupart des applications où l'on dispose d'une source de vibrations qu'il est possible d'exploiter pour une conversion d'énergie, la fréquence n'est pas constante mais varie sur une plage de quelques Hertz, à quelques dizaines de Hertz, voire une centaine de Hertz, autour de la fréquence de résonance de l'élément piézoélectrique. Il est donc important de pouvoir utiliser un générateur piézoélectrique large bande.

Un mode de réalisation pallie tout ou partie des inconvénients des générateurs piézoélectriques actuels.

Un mode de réalisation propose une solution large bande, c'est-à-dire fonctionnant sur une plage de fréquences de vibrations de plusieurs dizaines de Hertz.

Ainsi, un mode de réalisation prévoit un générateur piézoélectrique comportant :
un élément piézoélectrique ;
un circuit de commutation relié à l'élément piézoélectrique ;
un convertisseur inductif ; et
un circuit de commande du circuit de commutation pour, séquentiellement :
   - mettre en court-circuit l'élément piézoélectrique ;
   - mettre en circuit ouvert l'élément piézoélectrique ; et
   - connecter l'élément piézoélectrique au convertisseur inductif.

Selon un mode de réalisation :
le passage de la mise en court-circuit à la mise en circuit ouvert de l'élément piézoélectrique dépend d'une information représentative de la déformation de l'élément piézoélectrique ; et
le passage de la mise en circuit ouvert à la connexion de l'élément piézoélectrique au convertisseur inductif dépend de la tension aux bornes de l'élément piézoélectrique.

Selon un mode de réalisation, les conditions de passage de la mise en court-circuit à la mise en circuit ouvert de l'élément piézoélectrique et de passage de la mise en circuit ouvert à la connexion de l'élément piézoélectrique au convertisseur inductif sont définies par un régulateur du point maximal de puissance pour maximiser l'énergie transférée à une charge alimentée par le convertisseur inductif.

Selon un mode de réalisation, le générateur comporte au moins un interrupteur commandé par le circuit de commande pour réaliser la mise en court-circuit ou en circuit ouvert.

Selon un mode de réalisation, le passage de l'état dans lequel l'élément piézoélectrique est connecté au convertisseur inductif à l'état dans lequel l'élément piézoélectrique est en court-circuit s'effectue lorsque la tension aux bornes de l'élément piézoélectrique est nulle.

Selon un mode de réalisation, l'élément piézoélectrique est séquentiellement :
mis en court-circuit ;
mis en circuit ouvert ; et
connecté au convertisseur inductif.

Selon un mode de réalisation, ledit circuit de commutation est commandé pour optimiser le transfert d'énergie vers une charge alimentée par le convertisseur inductif.

Selon un mode de réalisation, ledit circuit de commutation inclut un redresseur de tension.

Selon un mode de réalisation, ledit circuit de commutation comporte un pont de redressement dont des bornes d'entrée sont reliées aux bornes de l'élément piézoélectrique et dont des bornes de sortie sont reliées en entrée du convertisseur inductif.

Selon un mode de réalisation, ledit circuit comporte deux interrupteurs en série, connectés aux bornes de l'élément piézoélectrique, le point milieu de l'association en série étant connecté à une des bornes de sortie du pont de redressement.

Selon un mode de réalisation, le convertisseur inductif comporte un transformateur dont un premier enroulement est connecté en série avec un troisième interrupteur entre lesdites bornes de sortie du pont.

Un mode de réalisation prévoit un générateur dans lequel ledit convertisseur inductif comporte un élément inductif en série avec un troisième interrupteur entre les bornes de sortie du pont de redressement.

Selon un mode de réalisation, ledit circuit comporte un interrupteur connecté entre lesdites bornes de sortie du pont.

Selon un mode de réalisation, ledit convertisseur inductif comporte un élément inductif en série avec un troisième interrupteur entre des bornes d'entrée d'un pont de redressement dont des bornes de sortie sont connectées à des bornes de sortie du générateur.

Selon un mode de réalisation, l'élément piézoélectrique est lié à ou est monté sur un objet mécanique susceptible de le faire vibrer.

Un mode de réalisation prévoit un procédé de commande d'un générateur piézoélectrique dont un élément piézoélectrique est susceptible d'être excité par un objet mécanique, comportant des phases successives de :
mise en court-circuit de l'élément piézoélectrique ;
mise en circuit ouvert de l'élément piézoélectrique ; et
transfert des charges accumulées pendant la phase du circuit ouvert à un convertisseur inductif.

Selon un mode de réalisation, la durée de la phase en circuit ouvert est fonction, entre autres, de l'amortissement et du couplage du type de générateur piézoélectrique utilisé, afin d'optimiser le transfert d'énergie vers une charge.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une représentation schématique d'un mode de réalisation d'un générateur piézoélectrique ;
les figures 2A, 2B, 2C et 2D illustrent, par des chronogrammes, le fonctionnement du générateur de la figure 1 ;
la figure 3 représente, de façon très schématique, un mode de réalisation d'un circuit de génération de signaux de commande du générateur piézoélectrique de la figure 1 ;
la figure 4 représente un mode de réalisation d'un circuit de fourniture d'une information représentative du courant dans l'élément piézoélectrique ; et
les figures 5, 6, 7 et 8 illustrent des variantes de réalisation d'un générateur piézoélectrique.

### Description détaillée

Par souci de clarté, seuls les éléments qui sont utiles à la compréhension des modes de réalisation décrits ont été représentés et seront détaillés. En particulier, la constitution et réalisation des circuits en aval du générateur piézoélectrique n'ont pas été détaillées, les modes de réalisation décrits étant compatibles avec les applications usuelles de récupération d'énergie vibratoire, par exemple les moteurs, fuselages d'avions, semelles de chaussures, pacemakers, interrupteurs, etc.

Il est à noter que, sur les figures, les éléments structurels et/ou fonctionnels communs aux différents modes de réalisation peuvent présenter les mêmes références et peuvent disposer de propriétés structurelles, dimensionnelles et matérielles identiques. Sauf précision contraire, les expressions "approximativement", "sensiblement" et "de l'ordre de" signifient à 10 % près, de préférence à 5 % près, ou à 10° près, de préférence à 5° près.

Sauf précision contraire, lorsque l'on fait référence à deux éléments connectés entre eux, cela signifie directement connectés sans élément intermédiaire autre que des conducteurs, et lorsque l'on fait référence à deux éléments reliés entre eux, cela signifie que ces deux éléments peuvent être directement reliés (connectés) ou être reliés par l'intermédiaire d'un ou plusieurs autres éléments.

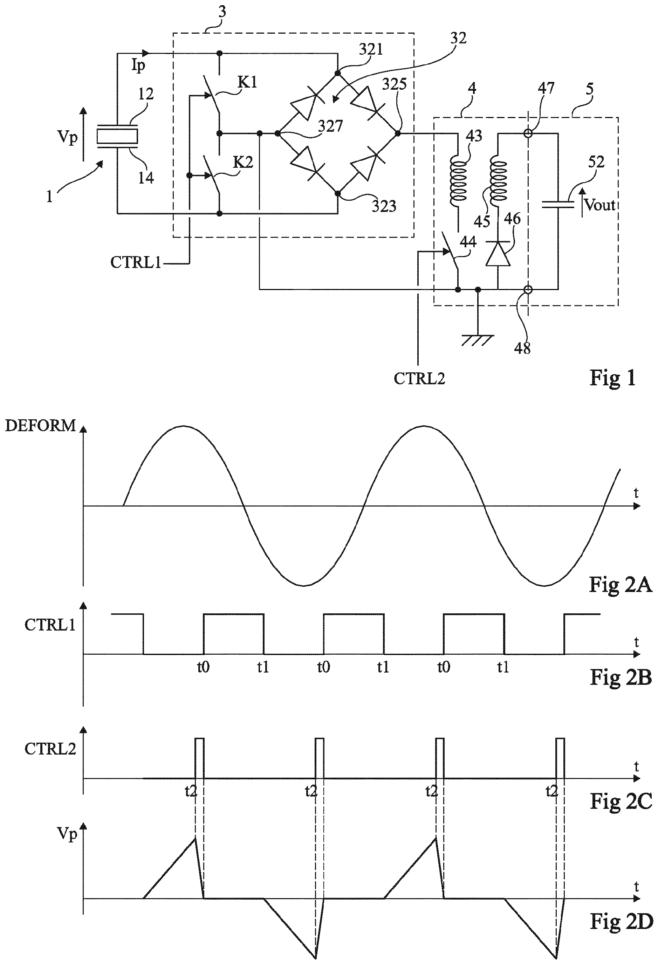

La figure 1 est une représentation schématique d'un mode de réalisation d'un générateur piézoélectrique.

Un tel générateur comporte un élément piézoélectrique 1, constitué d'un matériau piézoélectrique porté par, ou lié à, un objet (résonateur) mécanique susceptible de transformer des vibrations d'une structure en déformations appliquées sur le matériau piézoélectrique. Les deux électrodes 12 et 14 de l'élément piézoélectrique 1 sont reliées par un circuit 3 de commutation composé d'interrupteurs parmi lesquels au moins un interrupteur commandable.

Le rôle du circuit 3 est de permettre une mise en court-circuit et une mise en circuit ouvert des électrodes 12 et 14 de l'élément 1, ainsi que de redresser le signal prélevé entre ces électrodes. Dans l'exemple de la figure 1, on suppose que le circuit 3 comporte deux interrupteurs K1 et K2 en série commandés par un signal CTRL 1 et, reliant les électrodes 12 et 14 entre elles, et un pont de redressement 32 double alternance. Deux bornes 321 et 323 d'entrée du pont 32 sont respectivement connectées aux bornes 12 et 14. Deux bornes 325 et 327 de sortie redressée sont reliées aux entrées respectives d'un convertisseur inductif 4, la borne 327 étant en outre reliée au point milieu 34 de l'association en série des interrupteurs K1 et K2 et représentant la masse.

Le convertisseur inductif 4 a pour rôle de transférer l'énergie électrique produite par l'élément piézoélectrique 1 à une charge 5 (élément de stockage d'énergie tel une capacité 52 ou directement des circuits électroniques applicatifs). Le convertisseur 4 peut être un élément inductif, un transformateur, un convertisseur continu-continu, etc. Dans l'exemple de la figure 1, le convertisseur 4 est un transformateur dont un enroulement primaire 43 est en série avec un interrupteur 44, commandé par un signal CTRL2, entre les bornes 325 et 327. Un enroulement secondaire 45 du transformateur est en série avec une diode 46 entre des bornes 47 et 48 de sortie du convertisseur 4, reliées dans cet exemple, aux électrodes du condensateur 52 de stockage. La diode 46 empêche la décharge du condensateur 52 dans l'inductance 45. La borne 48 est reliée à la masse.

Les signaux CTRL1 et CTRL2 sont générés par un circuit (non représenté) en fonction des vibrations de l'élément piézoélectrique 1 pour respecter un transfert d'énergie à la résonnance de l'élément 1. Le fonctionnement se base sur un réglage des temps en circuit ouvert et en court-circuit de l'élément piézoélectrique 1 en prévoyant une décharge de l'élément à la fin des périodes en circuit ouvert dans le circuit inductif (résonance) afin de récupérer l'énergie accumulée dans l'élément piézoélectrique. Les phases de commutation successives sont court-circuit, circuit ouvert, résonance, court-circuit, circuit ouvert, résonance, court-circuit, etc. La durée cumulée des trois phases, court-circuit, circuit ouvert et résonance, correspond approximativement à une demi-période d'oscillation de l'élément piézoélectrique.

Les figures 2A, 2B, 2C et 2D illustrent, par des chronogrammes le fonctionnement du générateur de la figure 1.

La figure 2A illustre un exemple d'allure de la déformation DEFORM appliquée au matériau piézoélectrique soumis à des vibrations mécaniques. La figure 2B illustre l'allure du signal de commande CTRL1. La figure 2C illustre l'allure du signal de commande CTRL2. La figure 2D illustre l'allure de la tension Vp aux bornes de l'élément piézoélectrique 1.

L'élément piézoélectrique 1 est court-circuité pendant les périodes (entre des instants t0 et t1) où le signal CTRL1 est actif (interrupteurs K1 et K2 fermés). Pendant ces périodes, la tension Vp aux bornes de l'élément piézoélectrique 1 est nulle et les charges liées aux vibrations sont transférées d'une électrode à l'autre de l'élément 1. Aux instants t1, les interrupteurs K1 et K2 sont ouverts (l'élément 1 est en circuit ouvert car l'interrupteur 44 est également ouvert). La tension Vp aux bornes de l'élément 1 croît sous l'effet de la vibration à laquelle il est mécaniquement soumis (les charges s'accumulent dans la capacité du diélectrique et l'énergie est accumulée dans le matériau piézoélectrique quand il est en circuit ouvert). Quand la tension Vp atteint un niveau choisi comme on le verra par la suite, l'interrupteur 44 est fermé (signal CTRL2 actif) pour transférer les charges accumulées dans l'élément 1 dans l'inductance du primaire 43 du transformateur 4. Toute l'énergie stockée dans l'élément piézoélectrique entre les instants t1 et t0 est alors transférée dans l'inductance 43. Quand la tension Vp s'annule (fin du transfert d'énergie), on ouvre l'interrupteur 44 et on ferme de nouveau les interrupteurs K1 et K2 pour une nouvelle phase de court-circuit. A l'ouverture de l'interrupteur 44, l'énergie est transférée au secondaire 45 du transformateur 4 et dans la capacité de stockage 52.

Les signaux de commande CTRL1 et CTRL2 sont choisis pour ajuster la fréquence de résonance du système électromécanique incluant l'élément piézoélectrique 1 afin que celle-ci corresponde approximativement à la fréquence des vibrations du support (résonateur) mécanique portant le matériau piézoélectrique et pour réaliser l'adaptation d'impédance permettant la maximisation de l'énergie récupérée. En d'autres termes, on dimensionne les signaux CTRL1 et CTRL2 pour fixer la fréquence de résonance du système électromécanique (résonateur mécanique, matériau piézoélectrique et circuit) et pour optimiser le transfert d'énergie.

Le passage d'une phase à l'autre correspond aux conditions de fonctionnement suivantes :
- court-circuit vers circuit ouvert quand (instant t1) le courant dans l'élément piézoélectrique 1 atteint le niveau souhaité pour un fonctionnement à la résonance ;
- circuit ouvert vers résonance (instant t2) quand la tension aux bornes de l'élément piézoélectrique 1 atteint une valeur définie pour maximiser le transfert de puissance dans la capacité de stockage ; et
- résonance vers court-circuit (instant t0) quand la tension aux bornes de l'élément piézoélectrique 1 devient nulle.

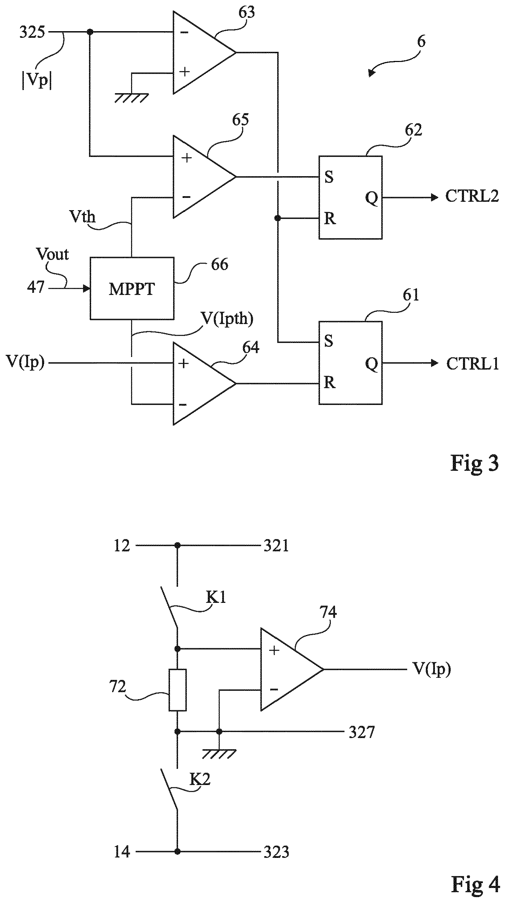

La figure 3 représente, de façon très schématique, un mode de réalisation d'un circuit 6 de génération des signaux de commande CTRL1 et CTRL2 du générateur piézoélectrique.

Ce circuit exploite trois informations :
- la valeur redressée |Vp| de la tension Vp aux bornes de l'élément piézoélectrique 1 ;
- une information représentative (fonction) de la déformation de l'élément piézoélectrique l, par exemple une information V(Ip) représentative du courant Ip dans l'élément 1, de sa vitesse ou de son accélération ; et
- une information représentative (fonction) de la puissance de sortie récupérée.

Le circuit 6 comporte deux bascules 61 et 62, de type RS, fournissant, sur leurs sorties directes (non inversées) respectives, les signaux CTRL1 et CTRL2. L'entrée de mise à un S de la bascule 61 et l'entrée de réinitialisation ou mise à zéro R de la bascule 62 sont connectées en sortie d'un comparateur 63 détectant la présence d'une tension non-nulle aux bornes de l'élément piézoélectrique 1. Le comparateur 63 reçoit, sur une première entrée (négative -) la valeur redressée |Vp| de la tension Vp (cette première entrée est par exemple connectée à la borne 325, figure 1). La deuxième entrée (positive +) du comparateur 63 est connectée à la masse. Le signal CTRL2 est donc forcé à zéro quand la tension Vp est nulle (entre les instants t0 et t1, figures 2A à 2D), c'est-à-dire quand l'élément 1 est mis en court-circuit, et le signal CTRL1 est mis à un dès que la tension Vp devient nulle (instants t0).

L'entrée de mise à zéro de la bascule 61 est connectée en sortie d'un comparateur 64 dont une première entrée (positive +) reçoit l'information V(Ip) représentative de la valeur du courant Ip dans l'élément 1 et dont une seconde entrée (négative -) reçoit une valeur V(Ipth) représentative d'un seuil Ipth de courant Ip. La fonction V() liant la valeur V(Ip) au courant Ip est cohérente (de préférence identique) à la fonction V() liant la valeur V(Ipth) au seuil Ipth. Ainsi, le signal CTRL1 est forcé à zéro pendant les périodes (entre les instants t1 et t0) où le courant Ip est inférieur au seuil Ipth.

L'entrée de mise à un S de la bascule 62 est connectée en sortie d'un comparateur 65 dont une première entrée (positive +) reçoit la valeur redressée |Vp| de la tension Vp et dont une seconde entrée (négative -) reçoit une valeur seuil Vth de la tension Vp. Ainsi, le signal CTRL2 est mis à un dès que la tension Vp devient, en valeur absolue, supérieure au seuil Vth.

Les seuils Vth et V(Ipth) sont générés (calculés), par exemple, par un régulateur du point maximal de puissance (MPPT - Maximum Power Point Tracking) pour maximiser l'énergie transférée à la charge (5, figure 1). L'information représentative de la puissance de sortie correspond, par exemple, à la tension Vout, une entrée du régulateur 66 étant connectée à la borne 47 (figure 1). Le régulateur 66 interprète alors les variations de la tension Vout entre les bornes 47 et 48 pour en déduire une diminution ou une augmentation de l'énergie transférée lors d'une période, et ainsi converger vers le couple de paramètre optimal. Tout circuit usuel de Suivi du Point Maximal de Puissance peut être utilisé pour générer et asservir les seuils Vth et V(Ipth) aux valeurs permettant le transfert d'énergie optimal.

L'obtention de l'information V(Ip) représentative du courant peut prendre différentes formes.

La figure 4 représente un mode de réalisation d'un circuit de fourniture d'une information représentative du courant dans l'élément piézoélectrique 1.

Une résistance 72 de faible valeur (quelques ohms à quelques dizaines d'ohms) est intercalée entre l'interrupteur K1 et le noeud 327 d'interconnexion des interrupteurs K1 et K2. On mesure la tension aux bornes de cette résistance 72, par exemple, avec un comparateur 74 dont les entrées sont connectées aux bornes respectives de la résistance 72. La sortie du comparateur 74 fournit une tension V(Ip) proportionnelle au courant Ip.

Selon un autre exemple non représenté, on utilise un miroir de courant commutable pour recopier alternativement (une demi-période sur deux) le courant circulant dans les interrupteurs K1 et K2. Selon encore un autre exemple non représenté, on mesure le déplacement ou l'accélération de l'élément piézoélectrique, par exemple en plaçant un capteur sur l'élément 1.

Un avantage des réalisations décrites est qu'il est désormais possible d'optimiser la récupération d'énergie d'un élément piézoélectrique malgré des variations de la fréquence des vibrations auxquelles il est soumis. En particulier, on peut désormais faire varier la fréquence de résonance de plusieurs dizaines de Hertz et couvrir notamment toute la plage de fréquences entre les fréquences de résonance en court-circuit et en circuit ouvert de l'élément piézoélectrique.

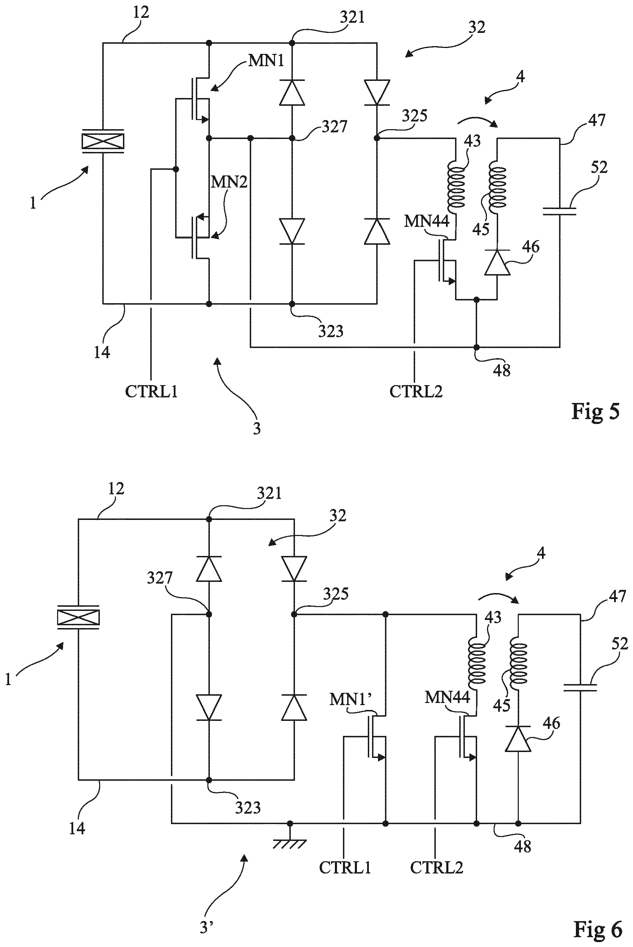

Les figures 5, 6, 7 et 8 illustrent des variantes de réalisation d'un générateur piézoélectrique basé sur les mêmes principes de commande que ceux exposés en relation avec les figures 1 à 4. Le circuit de génération des signaux CTRL1 et CTRL2 n'a pas été représenté aux figures 5 à 8. Les signaux de commande CTRL1 et CTRL2 sont identiques à ceux décrits en relation avec les figures précédentes.

Par rapport au mode de réalisation de la figure 1, le mode de réalisation de la figure 5 détaille que les interrupteurs K1, K2 et 44 sont des transistors MOS MN1, MN2 et MN44 (par exemple des transistors MOS à canal N). Les drains respectifs des transistors MN1 et MN2 sont connectés aux bornes 12 et 14 de l'élément piézoélectrique 1. Les sources des transistors MN1 et MN2 sont interconnectées à la borne 327 et leurs grilles reçoivent le signal CTRL1. Le transistor MN44 a sa source connectée à la borne 48 (ou 327). Son drain est connecté à l'inductance 43 et sa grille reçoit le signal CTRL2. Le reste est identique à la figure 1.

Dans le mode de réalisation de la figure 6, la mise en court-circuit s'effectue en aval du pont redresseur 32. Ainsi, un transistor MOS MN1' à canal N connecte les sorties 325 et 327 du pont 32. La grille du transistor MN1' reçoit le signal CTRL1, sa source est connectée à la borne 327 et son drain est connecté à la borne 325. Le reste du circuit de la figure 5 est identique à celui de la figure 4.

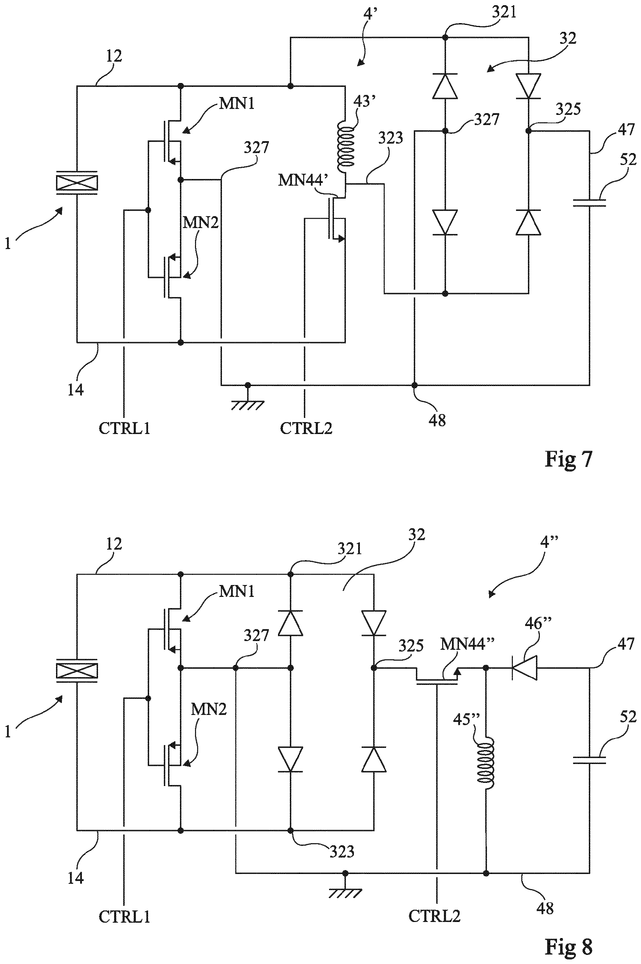

Dans le mode de réalisation de la figure 7, le convertisseur inductif 4' est constitué d'une seule inductance 43' en série avec un transistor MOS MN44' à canal N entre la borne 321 d'entrée du pont redresseur 32' double alternance et la borne 14 de l'élément 1 (la source étant côté borne 14). Le point milieu entre l'inductance 43' et l'interrupteur MN44' est connecté à l'autre entrée 323 du pont 32'. Les bornes 325 et 327 sont respectivement connectées aux bornes de sortie 47 et 48 (aux bornes du condensateur 52 dans cet exemple). Les transistors MN1 et MN2 sont toujours connectés en série entre les bornes 12 et 14, leurs sources communes étant connectées à la borne 327.

Dans le mode de réalisation de la figure 8, par rapport à la figure 4, le convertisseur inductif 4" est constitué d'un transistor MOS MN44", à canal N, en série avec une diode 46" entre une première borne d'entrée connectée à la borne 325 et une première borne de sortie 47 connectée à une électrode du condensateur 52. L'anode de la diode 46" est connectée à la borne 47 et sa cathode est connectée à la source du transistor MN44". Une inductance 45" connecte le point milieu de l'association en série entre le transistor MN44" et la diode 46" aux deuxièmes bornes d'entrée et de sortie du convertisseur 4", donc aux bornes 327 et 48.

Le fonctionnement des générateurs des figures 4 à 7 se déduit du fonctionnement exposé en relation avec les figures précédentes.

Divers modes de réalisation et variantes ont été décrits. Certains modes de réalisation et variantes pourront être combinés et d'autres variantes et modifications apparaîtront à l'homme de l'art. En particulier, le choix du matériau piézoélectrique, la forme de l'élément piézoélectrique et le dimensionnement du résonateur mécanique dépendent de la fréquence des vibrations auxquelles est soumis l'élément piézoélectrique. Une fois l'élément choisi, les intervalles de temps entre les différents cycles dépendent de la fréquence de résonance nominale du matériau piézoélectrique.

Enfin, la mise en oeuvre pratique des modes de réalisation et variantes qui ont été décrits est à la portée de l'homme de métier à partir des indications fonctionnelles données ci-dessus.

## Revendications

1. Générateur piézoélectrique comportant :
un élément piézoélectrique (1) ;
un circuit (3) de commutation relié à l'élément piézoélectrique ;
un convertisseur inductif (4 ; 4' ; 4") ; et
un circuit (6) de commande du circuit de commutation pour, séquentiellement :
- mettre en court-circuit l'élément piézoélectrique ;
- mettre en circuit ouvert l'élément piézoélectrique ; et
- connecter l'élément piézoélectrique au convertisseur inductif.

2. Générateur selon la revendication 1, dans lequel :
le passage de la mise en court-circuit à la mise en circuit ouvert de l'élément piézoélectrique (1) dépend d'une information représentative de la déformation de l'élément piézoélectrique ; et
le passage de la mise en circuit ouvert à la connexion de l'élément piézoélectrique au convertisseur inductif dépend de la tension aux bornes de l'élément piézoélectrique.

3. Générateur selon la revendication 2, dans lequel les conditions de passage de la mise en court-circuit à la mise en circuit ouvert de l'élément piézoélectrique (1) et de passage de la mise en circuit ouvert à la connexion de l'élément piézoélectrique au convertisseur inductif sont définies par un régulateur du point maximal de puissance pour maximiser l'énergie transférée à une charge (5) alimentée par le convertisseur inductif (4 ; 4' ; 4").

4. Générateur selon l'une quelconque des revendications 1 à 3, comportant au moins un interrupteur ((MN1, MN12) ; (MN1')) commandé (CTRL1, CTRL2) par le circuit de commande (6) pour réaliser la mise en court-circuit ou en circuit ouvert.

5. Générateur selon l'une quelconque des revendications 1 à 4, dans lequel le passage de l'état dans lequel l'élément piézoélectrique (1) est connecté au convertisseur inductif (4 ; 4' ; 4") à l'état dans lequel l'élément piézoélectrique est en court-circuit s'effectue lorsque la tension aux bornes de l'élément piézoélectrique est nulle.

6. Générateur selon l'une quelconque des revendications 1 à 5, dans lequel ledit circuit de commutation (3) est commandé pour optimiser le transfert d'énergie vers une charge (5) alimentée par le convertisseur inductif (4 ; 4' ; 4").

7. Générateur selon l'une quelconque des revendications 1 à 6, dans lequel ledit circuit de commutation (3) inclut un redresseur de tension (32 ; 32').

8. Générateur selon l'une quelconque des revendications 1 à 7, dans lequel ledit circuit de commutation (3 ; 3') comporte un pont de redressement (32) dont des bornes d'entrée (321, 323) sont reliées aux bornes de l'élément piézoélectrique (1) et dont des bornes de sortie (325, 327) sont reliées en entrée du convertisseur inductif (4 ; 4").

9. Générateur selon la revendication 8, dans lequel ledit circuit (3) comporte deux interrupteurs (K1, K2 ; MN1, MN2) en série, connectés aux bornes (12, 14) de l'élément piézoélectrique (1), le point milieu de l'association en série étant connecté à une (327) des bornes de sortie du pont de redressement (32).

10. Générateur selon la revendication 8 ou 9, dans lequel le convertisseur inductif (4) comporte un transformateur dont un premier enroulement (43) est connecté en série avec un troisième interrupteur (44 ; MN44) entre lesdites bornes (325, 327) de sortie du pont (32).

11. Générateur selon la revendication 8 ou 9, dans lequel ledit convertisseur inductif (4") comporte un élément inductif (45") en série avec un troisième interrupteur (MN44") entre les bornes de sortie (325, 327) du pont de redressement (32).

12. Générateur selon la revendication 8 ou selon la revendication 10 dans son rattachement à la revendication 8, dans lequel ledit circuit (3') comporte un interrupteur (MN1') connecté entre lesdites bornes (325, 327) de sortie du pont (32).

13. Générateur selon l'une quelconque des revendications 1 à 7, dans lequel ledit convertisseur inductif (4') comporte un élément inductif (43') en série avec un troisième interrupteur (MN44') entre des bornes d'entrée (321, 323) d'un pont de redressement (32') dont des bornes de sortie (325, 327) sont connectées à des bornes de sortie (47, 48) du générateur.

14. Générateur selon l'une quelconque des revendications 1 à 13, dans lequel l'élément piézoélectrique (1) est lié à ou est monté sur un objet mécanique susceptible de le faire vibrer.

15. Procédé de commande d'un générateur piézoélectrique dont un élément piézoélectrique (1) est susceptible d'être excité par un objet mécanique, comportant des phases successives de :
mise en court-circuit de l'élément piézoélectrique ;
mise en circuit ouvert de l'élément piézoélectrique ; et
transfert des charges accumulées pendant la phase du circuit ouvert à un convertisseur inductif (4 ; 4' ; 4").

16. Procédé selon la revendication 15, dans lequel la durée de la phase en circuit ouvert est fonction, entre autres, de l'amortissement et du couplage du type de générateur piézoélectrique utilisé, afin d'optimiser le transfert d'énergie vers une charge (5).

## Patentansprüche

1. Piezoelektrischer Generator, der Folgendes aufweist:
ein piezoelektrisches Element (1);
einen Schaltkreis (3) der mit dem piezoelektrischen Element gekoppelt ist;
einen induktiven Wandler (4; 4'; 4"); und
eine Schaltung (6) zum Steuern des Schaltkreises, zum sequentiellen
- Kurzschließen des piezoelektrischen Elements;
- Platzieren des piezoelektrischen Elements in einen offenen Stromkreis; und
- Verbinden des piezoelektrischen Elements mit dem induktiven Wandler.

2. Generator nach Anspruch 1, wobei:
das Umschalten vom Kurzschließen zum Platzieren des piezoelektrischen Elements (1) in einen offenen Stromkreis von Informationen abhängt, die für die Verformung des piezoelektrischen Elements repräsentativ sind; und
das Umschalten vom offenen Stromkreis zur Verbindung des piezoelektrischen Elements mit dem induktiven Wandler von der Spannung am piezoelektrischen Element abhängt.

3. Generator nach Anspruch 2, wobei die Bedingungen für das Umschalten vom Kurzschließen zum Platzieren des piezoelektrischen Elements (1) in einen offenen Stromkreis und für das Umschalten vom offenen Stromkreis zur Verbindung des piezoelektrischen Elements mit dem induktiven Wandler durch einen Regler des Punktes maximaler Leistung definiert sind, um die Energie zu maximieren, die an eine von dem induktiven Wandler (4; 4'; 4") gespeiste Last (5) übertragen wird.

4. Generator nach einem der Ansprüche 1 bis 3, mit wenigstens einem Schalter ((MN1, MN12); (MN1')), der von der Steuerschaltung (6) gesteuert (CTRL1, CTRL2) wird, um das Kurzzuschließen oder das Platzieren in einen offenen Stromkreis zu bewirken.

5. Generator nach einem der Ansprüche 1 bis 4, wobei das Umschalten von dem Zustand, in dem das piezoelektrische Element (1) mit dem induktiven Wandler (4; 4'; 4") verbunden ist, zu dem Zustand, in dem das piezoelektrische Element kurzgeschlossen ist, durchgeführt wird, wenn die Spannung an dem piezoelektrischen Element Null ist.

6. Generator nach einem der Ansprüche 1 bis 5, wobei der Schaltkreis (3) gesteuert wird, um die Energieübertragung zu einer Last (5) zu optimieren, die von dem induktiven Wandler (4; 4'; 4") gespeist wird.

7. Generator nach einem der Ansprüche 1 bis 6, wobei der Schaltkreis (3) einen Spannungsgleichrichter (32; 32') aufweist.

8. Generator nach einem der Ansprüche 1 bis 7, wobei der Schaltkreis (3; 3') eine Gleichrichterbrücke (32) mit über das piezoelektrische Element (1) gekoppelten Eingangsanschlüssen (321, 323) und mit an den Eingang des induktiven Wandlers (4; 4") gekoppelten Ausgangsanschlüssen (325, 327) aufweist.

9. Generator nach Anspruch 8, wobei der Schaltkreis (3) zwei in Reihe geschaltete Schalter (K1, K2; MN1, MN2) aufweist, die mit den Anschlüssen (12, 14) des piezoelektrischen Elements (1) verbunden sind, wobei der Verbindungspunkt der Schalter mit einem (327) der Ausgangsanschlüsse der Gleichrichterbrücke (32) verbunden ist.

10. Generator nach Anspruch 8 oder 9, wobei der induktive Wandler (4) einen Transformator mit einer ersten Wicklung (43) aufweist, die mit einem dritten Schalter (44; MN44) zwischen den Ausgangsanschlüssen (325, 327) der Brücke (32) in Reihe geschaltet ist.

11. Generator nach Anspruch 8 oder 9, wobei der induktive Wandler (4") ein induktives Element (45") aufweist, das mit einem dritten Schalter (MN44") zwischen den Ausgangsanschlüssen (325, 327) der Gleichrichterbrücke (32) in Reihe geschaltet ist.

12. Generator nach Anspruch 8 oder nach Anspruch 10 und nach Anspruch 8, wobei der Schaltkreis (3') einen Schalter (MN1') aufweist, der zwischen die Ausgangsanschlüsse (325, 327) der Brücke (32) geschaltet ist.

13. Generator nach einem der Ansprüche 1 bis 7, wobei der induktive Wandler (4') ein induktives Element (43') aufweist, das in Reihe geschaltet ist mit einem dritten Schalter (MN44'), und zwar zwischen Eingangsanschlüssen (321, 323) einer Gleichrichterbrücke (32') mit Ausgangsanschlüssen (325, 327), die mit Ausgangsanschlüssen (47, 48) des Generators verbunden sind.

14. Generator nach einem der Ansprüche 1 bis 13, wobei das piezoelektrische Element (1) an ein mechanisches Objekt, das in der Lage ist, es in Schwingung zu versetzen, gekoppelt oder daran angebracht ist.

15. Verfahren zum Steuern eines piezoelektrischen Generators mit einem piezoelektrischen Element (1), das durch ein mechanisches Objekt erregt werden kann, wobei das Verfahren folgende aufeinanderfolgenden Phasen aufweist:
Kurzschließen des piezoelektrischen Elements;
Platzieren des piezoelektrischen Elements in einen offenen Stromkreis; und
Übertragen der während der Phase des offenen Stromkreises gespeicherten Ladungen an einen induktiven Wandler (4; 4'; 4").

16. Verfahren nach Anspruch 15, wobei die Dauer der Phase des offenen Stromkreises eine Funktion u.a. der Dämpfung und der Kopplung des verwendeten piezoelektrischen Generators ist, um die Leistungsübertragung an eine Last (5) zu optimieren.

## Claims

1. A piezoelectric generator comprising:
a piezoelectric element (1);
a switching circuit (3) coupled to the piezoelectric element;
an inductive converter (4; 4'; 4"); and
a circuit (6) for controlling the switching circuit to, sequentially:
- short the piezoelectric element;
- place the piezoelectric element in open circuit; and
- connect the piezoelectric element to the inductive converter.

2. The generator of claim 1, wherein:
the switching from the shorting to the placing in open circuit of the piezoelectric element (1) depends on information representative of the deformation of the piezoelectric element; and
the switching from the open circuit to the connection of the piezoelectric element to the inductive converter depends on the voltage across the piezoelectric element.

3. The generator of claim 2, wherein the conditions of the switching from the shorting to the placing in open circuit of the piezoelectric element (1) and of the switching from the open circuit to the connection of the piezoelectric element to the inductive converter are defined by a regulator of the maximum power point to maximize the energy transferred to a load (5) powered by the inductive converter (4; 4'; 4").

4. The generator of any of claims 1 to 3, comprising at least one switch ((MN1, MN12); (MN1')) controlled (CTRL1, CTRL2) by the control circuit (6) to perform the shorting or the placing in open circuit.

5. The generator of any of claims 1 to 4, wherein the switching from the state where the piezoelectric element (1) is connected to the inductive converter (4; 4'; 4") to the state where the piezoelectric element is shorted is performed when the voltage across the piezoelectric element is zero.

6. The generator of any of claims 1 to 5, wherein said switching circuit (3) is controlled to optimize the energy transfer to a load (5) powered by the inductive converter (4; 4'; 4") .

7. The generator of any of claims 1 to 6, wherein said switching circuit (3) includes a voltage rectifier (32; 32').

8. The generator of any of claims 1 to 7, wherein said switching circuit (3; 3') comprises a rectifying bridge (32) having input terminals (321, 323) coupled across the piezoelectric element (1) and having output terminals (325, 327) coupled to the input of the inductive converter (4; 4").

9. The generator of claim 8, wherein said circuit (3) comprises two series-connected switches (K1, K2; MN1, MN2), connected to the terminals (12, 14) of the piezoelectric element (1), the junction point of the switches being connected to one (327) of the output terminals of the rectifying bridge (32).

10. The generator of claim 8 or 9, wherein the inductive converter (4) comprises a transformer having a first winding (43) series-connected with a third switch (44; MN44) between said output terminals (325, 327) of the bridge (32).

11. The generator of claim 8 or 9, wherein said inductive converter (4") comprises an inductive element (45") series-connected with a third switch (MN44") between the output terminals (325, 327) of the rectifying bridge (32).

12. The generator of claim 8 or of claim 10 and of claim 8, wherein said circuit (3') comprises a switch (MN1') connected between said output terminals (325, 327) of the bridge (32).

13. The generator of any of claims 1 to 7, wherein said inductive converter (4') comprises an inductive element (43') series-connected with a third switch (MN44') between input terminals (321, 323) of a rectifying bridge (32') having output terminals (325, 327) connected to output terminals (47, 48) of the generator.

14. The generator of any of claims 1 to 13, wherein the piezoelectric element (1) is coupled or is assembled on a mechanical object capable of making it vibrate.

15. A method of controlling a piezoelectric generator having a piezoelectric element (1) capable of being excited by a mechanical object, comprising successive phases of:
shorting the piezoelectric element;
placing the piezoelectric element in open circuit; and
transferring the charges stored during the open circuit phase to an inductive converter (4; 4'; 4").

16. The method of claim 15, wherein the duration of the open circuit phase is a function, among others, of the damping and of the coupling of the type of piezoelectric generator used, to optimize the power transfer to a load (5).
